(19) Europäisches Patentamt
European Patent Office
Office européen des brevets

(11) **EP 4 354 347 A1**

(12) **EUROPEAN PATENT APPLICATION**

(43) Date of publication:
**17.04.2024 Bulletin 2024/16**

(21) Application number: **23202358.0**

(22) Date of filing: **09.10.2023**

(51) International Patent Classification (IPC):
**G06N 3/0464** (2023.01)        **G06N 3/065** (2023.01)
**G06N 3/048** (2023.01)

(52) Cooperative Patent Classification (CPC):
**G06N 3/065; G06N 3/0464; G11C 11/54;
G11C 13/0002; G06N 3/048**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **11.10.2022 US 202263415147 P**

(71) Applicant: **The University of Hong Kong
Hong Kong (CN)**

(72) Inventors:
• **REN, Yuan**
  **Tianjin (CN)**
• **Wong, Ngai**
  **Hong Kong (HK)**
• **LI, Can**
  **Hong Kong (HK)**
• **WANG, Zhongrui**
  **Hong Kong (HK)**

(74) Representative: **HGF**
  **HGF Limited**
  **1 City Walk**
  **Leeds LS11 9DX (GB)**

(54) **SYSTEM AND METHOD FOR ADDITION AND SUBTRACTION IN MEMRISTOR-BASED IN-MEMORY COMPUTING**

(57) A method of measuring cross-correlation or similarity between input features and filters of neural networks using an RRAM-crossbar architecture to carry out addition/subtraction-based neural networks for in-memory computing. The correlation calculations use L1 norm operations of AdderNet. The RCM structure of the RRAM-cross bar has storage and computing collocated, such that processing is done in the analog domain with low power, low latency and small area. In addition, the impact due to the nonidealities of RRAM device can be alleviated by the implicit ratio-based feature of the structure.

(a)

FIG.1A

(b)

FIG. 1B
(PRIOR ART)

EP 4 354 347 A1

**Description**

**Field of the Invention**

The present invention relates to the measurement of the cross-correlation between input features and filters of neural networks and, more particularly, to the making of such measurements using addition/subtraction-based neural networks.

**Background of the Invention**

Innovative deep learning networks and their unique deployment strategies that simultaneously consider both the high accuracy of artificial intelligence (AI) algorithms and the high performance of hardware implementations are increasingly sought, especially in resource-constrained edge applications. In deep neural networks, convolution is widely used to measure the similarity between input features and convolution filters, but it involves a large number of multiplications between floating-point values. See for example US Patent No. 10,740,671 which discloses convolutional neural networks using a resistive processing unit array and is based on a traditional convolutional neural network using multiplication operations in the resistive processing unit array. See Also US Patent No. 10,460,817, which describes the traditional multiplication-based (convolution-based) neural network using multi-level non-volatile memory (NVM) cells; and US Patent No. 9,646,243 which uses general resistive processing unit (RPU) arrays to deploy traditional CNN systems.

Compared with complex multiplication operations, addition/subtraction operations have lower computational complexity.

A cutting-edge neural network based on addition/subtraction operation (AdderNet) has emerged to replace these massive multiplications in deep neural networks, especially convolutional neural networks (CNNs), so as to reduce computational costs and as an attractive candidate for realizing AI accelerator chips. See Chen H, Wang Y, Xu C, Shi B, Xu C, Tian Q, Xu C, "AdderNet: Do we really need multiplications in deep learning?," Proceedings of the IEEE/CVF Conference on Computer Vision and Pattern Recognition 2020 (pp. 1468-1477). Further see, "AdderNet and its Minimalist Hardware Design for Energy-Efficient Artificial Intelligence", https://arxiv.org/abs/2101.10015. The Wang article implements addition/subtraction operations on field programmable gate arrays.

Specifically, assuming that there is a 3-dimensional input feature (Hi,Wi,Ci) and multiple 3-dimensional filters (K,K,Ci), where the number of filters (i.e., filter depth) is Co, mathematical methods can be used to quantify the process of similarity calculation as follows:

$$OUT(p,q,v) = \sum_{u=0}^{Ci}\sum_{j=0}^{K}\sum_{i=0}^{K} f\big(IN(p+i,q+j,u),F(i,j,u,v)\big) \qquad (1.1)$$

where OUT ($p \in Ho$, $q \in Wo$, $v \in Co$) represents the output results of a similarity calculation between input feature IN ($p+i \in Hi$, $q+j \in Wi$, $u \in Ci$) and filter F ($i \in K$, $j \in K$, $u \in Ci$, $v \in Co$). The function f denotes the method for calculating the similarity. In traditional CNN, a convolution operation is used to calculate the cross-correlation as a way to characterize the similarity, which will inevitably introduce a large number of expensive multiplication operations. However, the calculation of similarity can be realized by another metric of distance. The core of the addition/subtraction-based neural network is that the L1 norm distance is used as the output response, instead of the convolution operation between the input feature and the filter. The L1 distance is the sum of the absolute values of the coordinate difference between two points, so no multiplication is involved throughout. The similarity calculation in an addition/subtraction-based neural network becomes the following additive form (1.2) or subtractive form (1.3), respectively.

$$OUT(p,q,v) = -\sum_{u=0}^{Ci}\sum_{j=0}^{K}\sum_{i=0}^{K} \big|IN(p+i,q+j,u) + \big(-F(i,j,u,v)\big)\big| \qquad (1.2)$$

$$OUT(p,q,v) = -\sum_{u=0}^{Ci}\sum_{j=0}^{K}\sum_{i=0}^{K} \big|IN(p+i,q+j,u) - F(i,j,u,v)\big| \qquad (1.3)$$

It can be seen that the calculation in equations (1.2) and (1.3) only needs to use addition or subtraction. By changing the measurement method of calculating the similarity from a convolution operation to L1 norm distance, addition/subtraction can be used to extract the features in the neural network and construct the addition/subtraction-based neural networks.

In addition, Resistive Random Access Memory (RRAM)-based in-memory computing (IMC) is a promising way to fuel the next-generation of AI chips featuring high speed, low power and low latency. Therefore, the strategy of the cutting-edge addition/subtraction-based neural network (AdderNet)-based in-memory computing (IMC) AI accelerator, offers the full benefits of both addition/subtraction operation and a high degree of parallelism.

However, there is a first problem, i.e., that the addition/subtraction operations cannot be deployed directly into the cross-barred RRAM IMC system. There is also a second problem, i.e., that the non-ideal characteristics of the RRAM device (non-idealities) can have a severe impact on the actual deployment and may significantly degrade the accuracy of the artificial neural networks (ANN).

## Summary of the Invention

According to the present invention the first problem, i.e., the use of RRAM devices in AdderNet, can be overcome by specially designed topology and the connection of the RRAM crossbar array and peripheral circuits in a way that allows two factors in different circuit-level dimensions to be operated in the same dimension in addition/subtraction operations. In terms of the second problem, this innovation enables the absolute value of RRAM conductance, which is decisive for the accuracy of the ANN hardware system, to become a ratio of two conductance values, which is a relative value, so that the ratio does not change dramatically when the conductance of RRAM devices changes due to process variation and temperature change.

Thus, the present invention is a new use and improvement to the existing RRAM device cell. This innovation allows the RRAM-crossbar array to perform addition/subtraction operations, and it has an inherent capacity for tolerance against the non-ideal characteristics of these devices.

According to a first aspect of the present disclosure there is provided a method of measuring cross-correlation or similarity between input features and filters of neural networks using an RRAM-crossbar architecture to carry out addition/subtraction-based neural networks for in-memory computing in parallel, wherein the correlation calculations use L1 norm operations of AdderNet, and wherein an RCM structure of the RRAM-cross bar has storage and computing collocated, such that processing is done in the analog domain; and nonidealities of the RRAM crossbar are alleviated by the implicit ratio-based feature of the structure.

According to a second aspect of the present disclosure there is provided a fully integrated RRAM-Based AI Chip comprising multiple ratio-based crossbar micros (RCMs); global input and output buffers; and input/output interfaces

The RCM may comprise: a plurality of process elements (PE) that provide basic weight storage and a computation unit, wherein the PEs are arranged in rows M and columns N, and wherein inference is performed in a parallel mode by activating each row; multi-channel shared analog-to-digital converters (ADCs) wherein each ADC receives the output of a column of PEs and produces the output of the RCM; and multiple digital-to-analog converters (DAC) that apply input signals to rows of PEs as the input to the RCM.

Optionally, according to a scheme #1, the RCM has an architecture for addition with a size (M*2N) with left and right arrays and a 1T1R PE.

Optionally, when an addition operation is to be performed, the RCM has PEs in the form of one transistor and at least one resistor (1T1R) structure, a top electrode of the RRAM connects to a bit line (BL) as an interface connecting the output of the previous layer and the input of the current layer, a bottom electrode of the RRAM cell connects to the drain of the transistor and the gate of the transistor is controlled by a word line (WL); wherein the sub-currents at the source of the transistors are collected by the source line (SL) as the current sum output of each column; and wherein according to a scheme #2 RCM has an architecture for addition with a size (2M*N), where it contains two arrays with the same size - an upper one (M*N) and a lower one (M*N), where M is the number of rows and N is the number of columns in the RRAM crossbar.

Optionally, in terms of the input, the output vector voltages of the previous layer are fed to the BLs of the upper (M*N) array as the input vector voltages of the current layer, while a constant voltage bias connects the BLs of the lower (M*N) array; as for the RRAM conductance, all of the conductance of (M*N) RRAM cells in the upper array are set to a constant value such as Gbias, while the conductance of the (M*N) RRAM cells in the lower array are mapped to the synaptic weights of neural networks; and the current outputs of the columns are read out through SLs in parallel. Then the currents are digitalized by current-sense amplifiers (CSAs) and analog-to-digital converters (ADCs) for further nonlinear activation and batch normalization operations.

Optionally, according to a scheme #3, the RCM has an architecture for addition with a single size (M*N) and a 2T2R PE.

Optionally, according to a scheme #4, the RCM has an architecture for addition with a single size (M*N) and a 1T2R PE.

Optionally, one RRAM cell connects to the BL while the other RRAM cell connects to the constant bias voltage (Vbias), a bottom electrode of the RRAM cell connects to the drain of the transistor and the gate of the transistor is controlled by a word line (WL); and wherein the sub-currents at the source of the transistors are collected by the source line (SL) as the current sum output of each column.

Optionally, according to a scheme #5, the RCM has an architecture for addition with a single size (2M*N) with upper and lower arrays and a 1T1RPE.

Optionally, according to a scheme #6, the RCM has an architecture for addition with a single size (M*N) and a 2T2R PEThe fully integrated RRAM-Based AI Chip according to claim 3 wherein according to a scheme #7 for a subtraction operation is to be performed the RCM has a size (2M*1N) with upper and lower arrays and a 1T1R PE, where M is the number of rows and N is the number of columns in the RRAM crossbar; wherein the RCM contains two arrays with the same size - a left one (M*N) and a right one (M*N); wherein for the input, the output vector voltages of the previous layer are fed to the BLs of the upper (M*N) array as the input vector voltages of the current layer, while a constant voltage bias connects the BLs of the lower (M*N) array; all of the conductance of the (M*N) RRAM cells in the upper array are set to a constant value such as Gbias, while the conductance of the (M*N) RRAM cells in lower array are mapped to the synaptic weights of neural networks; and wherein for the output, the current outputs of the columns are read out through SL lines in parallel and then the current SLP[j] and SLN[j] are subtracted and digitalized by current sense amplifiers and analog-to-digital converters for further nonlinear activation and batch normalization operations.

Optionally, according to a scheme #8 for a subtraction operation to be performed the RCM has a size (M*N) in a single array and a 2T2R PE.

Optionally, according to a scheme #9 for a subtraction operation to be performed the RCM has a size (M*N) in a single array and a 1T1R PE.

Optionally, element-wise absolute value calculation is implemented at the circuit level by a sequential read-out implementation scheme for multi-bit quantized inputs and weights, wherein the sequential read-out implementation scheme comprises the steps of: after a nonlinear activation operation on the previous layer, quantizing the output signal into the multi-bit in digital domain, using digital-to-analog converters (DACs) to transfer the multi-bit digital signal to an analog signal as the inputs of the RCM where synaptic weights are quantized and mapped onto their respective RRAM devices and one single RRAM cell with multiple states represents one synaptic weight; using the CSAs and ADCs to read out and digitalize the current sum on the columns of the RCM in a row-by-row fashion and formatting the ADC digital output in a specialized form that is the sign bit plus the absolute value bit.

Optionally, an adder and register accumulate the sum in multiple clock cycles.

Optionally, the fully integrated RRAM-Based AI Chip further implements pointwise convolution comprising the steps of: where the size of an input feature map (IFM) is (Hi*Wi*Ci) and the size of a filter is (K*K*Ci*Co), each (K*K*Ci) filter is divided into (K*K) filters with (1*1*Ci) size for each one in each RCM, L1-norm similarity is realized in a pointwise domain and there are (K*K) such RCMs; in the horizontal direction of all (K*K) of such RCMs, each element is operated in parallel; and the summation of the (K*K) pointwise results are operated at the backend using an adder.

**Brief Description of the Drawings**

This patent or application file contains at least one drawing executed in color. Copies of this patent or patent application publication with color drawing(s) will be provided by the Office upon request and payment of the necessary fee.

The foregoing and other objects and advantages of the present invention will become more apparent when considered in connection with the following detailed description and appended drawings in which like designations denote like elements in the various views, and wherein:

FIGS. **1A** and **1B** show two ways of comparing feature visualization, where FIG. 1A is for AdderNets and FIG. 1B is for traditional prior art CNNs;

FIG. **2A** illustrates the layout of a fully integrated RRAM-based AI accelerator chip for IMC according to the present invention and **FIG. 2B** shows the layout of the ratio-based crossbar micro (RCM) in the circuit of FIG. 2A;

FIG. **3** shows a layout or architecture for an RRAM-crossbar operating according to a Scheme #1 addition case with a 1T1R process element (PE) unit structure;

FIG. **4** shows a layout or architecture for an RRAM-crossbar operating according to a Scheme #2 addition case with a 1T1R PE unit structure;

FIG. **5** shows a layout or architecture for an RRAM-crossbar operating according to a Scheme #3 addition case with a 2T2R PE unit structure;

FIG. **6** shows a layout or architecture for an RRAM-crossbar operating according to a Scheme #4 addition case with a 1T2R PE unit structure;

FIG. **7** shows a layout or architecture for an RRAM-crossbar operating according to a Scheme #5 addition case with a 1T1R PE unit structure;

FIG. 8 shows a layout or architecture for an RRAM-crossbar operating according to a Scheme #6 addition case with a 2T2R PE unit structure;

FIG. 9 shows a layout or architecture for an RRAM-crossbar operating according to a Scheme #7 subtraction case with a 1T1R PE unit structure;

FIG. 10 shows the relationship of voltage and current at various nodes for a 1T1R, a 2T2R, and a 1T2R PE unit according to the subtraction case;

FIG. 11 shows a layout or architecture for an RRAM-crossbar operating according to a Scheme #8 subtraction case with a 2T2R PE unit structure;

FIG. 12 shows a layout or architecture for an RRAM-crossbar operating according to a Scheme #9 subtraction case with a 1T2R PE unit structure;

FIG. 13 shows a conventional implementation of Scheme #2 for applying an L1-norm calculation in RCMs; and

FIG. 14 shows a pointwise L1-norm calculation scheme in RCMs according to the present invention.

## Detailed Description of the Invention

In order to reduce hardware resource consumption and increase integration on fully integrated resistive random-access memory (RRAM) AI accelerator chips, a novel addition/subtraction-based RRAM-crossbar hardware architecture is proposed for realizing high accuracy, low latency, low energy and small chip size. Specifically, a new topology is proposed in which the addition or subtraction can be realized in parallel on an RRAM crossbar. Besides a novel elementwise absolute value scheme, the L1 norm of AdderNet can be calculated automatically on the RRAM-crossbar hardware so as to measure the cross-correlation between input features and filters of neural networks. The conductance non-ideal issue of the RRAM device must still be conquered. However, thanks to the inherent ratio-based scheme of the present invention, the non-ideal tolerance of the RRAM AI chip brings excellent robustness and competitiveness.

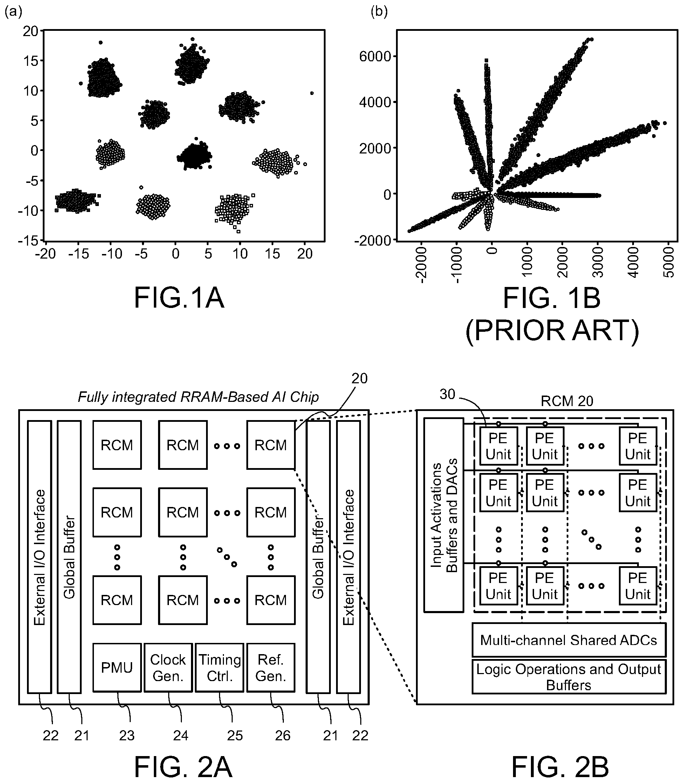

In order to verify the effectiveness of the addition/subtraction-based neural networks, the visualization of features in AdderNet and CNN are shown in FIGS. 1A and 1B. It can be seen that different categories are separated according to the angle in the traditional CNN system because of the use of cross-correlation as the measurement of feature extraction, FIG. 1B. In contrast to conventional CNN, the L1 norm distance used by AdderNet divides different categories into different cluster centers, FIG. 1A. Both methods can successfully and accurately separate different categories in image classification tasks, which proves that AdderNet can have the same feature extraction ability as traditional CNN.

Building on top of the addition/subtraction-based neural networks (AdderNet) algorithm, a novel addition/subtraction-based RRAM-crossbar hardware architecture reduces hardware resource consumption, alleviates the impact of nonidealities of the devices and increases integration on the fully integrated RRAM-based AI accelerator chips for in-memory computing on edge.

A layout of the fully integrated RRAM-based AI accelerator chip according to the present invention for in-memory computing (IMC) is shown in FIG. 2A. This design mainly contains multiple Ratio-based Crossbar Micros (RCMs) 20, global buffers 21, I/O interfaces 22, as well as other peripheral blocks such as power management unit (PMU) 23 for providing different analog and digital power supplies for the whole system, clock generator 24 for generating the high-frequency clock signal, timing logic control module 25 for providing the clock control logic with signals for writing/reading data on RCMs, and reference generator 26 for generating the different reference voltages or currents. Inside the RCM, as shown in FIG. 2B, process element (PE) units 30 represent the basic weight storage and computation unit, which can be a 1-transistor-1-resistor (1T1R) structure or a 1-transistor-2-resistor (1T2R) or a 2-transistor-2 resistor (2T2R) structure for different topologies in the present invention. In the design of the present invention, the inference (i.e., the process of drawing conclusions or making decisions based on facts and evidence) is performed in parallel mode by activating each row. Moreover, a multi-channel sharing technique is applied (e.g., 8 columns share one analog-to-digital converter (ADC)), which saves space since the peripheral ADC size is typically much larger than the column pitch of the RCM.

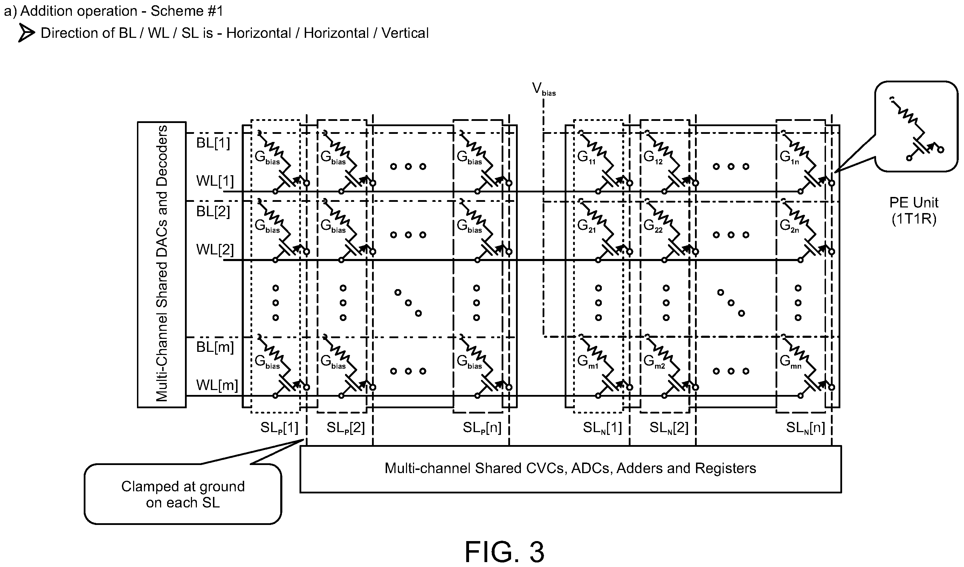

A ratio-based crossbar micro (RCM) contains two different topologies corresponding to two scenarios which are the case of an addition operation and a subtraction operation using different PE units with different structures like 1T1R, 1T2R or 2T2R as shown in FIG. 3.

A wide range of structural schemes for an RRAM-crossbar array are proposed for addition and subtraction, respectively. FIG. 3 illustrates an addition operation, Scheme #1, that has a ratio-based crossbar micro (RCM) with a size (M*2N) when an addition operation is applied, where it contains two arrays with the same size - the left one (M*N) and the right one (M*N). M is the number of rows, while N is the number of columns in an RRAM crossbar. Each processing element (PE) unit is a 1-transistor-1-resistor (1T1R) structure. In FIG. 3, note that the current $SL_P[i]$ and $SL_N[i]$ are added by the single-end current sense amplifiers (CSA). CVC stands for current-to-voltage converter made by a single-end CSA, ADC stands for analog-to-digital converter and DAC stands for digital-to-analog converter.

The four main aspects of scheme #1 are described as follows, where BL is the bit line, WL is the word line and SL is the source line:

1). Direction of BL / WL / SL. In this arrangement BL and WL are parallel (horizontal direction), while SL is perpendicular to BL and WL (vertical direction), which means each WL[i] can control an entire row (including left array and right array) corresponding to the same input BL[i] and the synaptic weights (represented as conductance G[ij]). It ultimately leads to the parallel output of current on each SLP[j] and SLN[j].

2). Input signal on each row. As for the input, the output vector voltages of the previous layer are fed to the BLs of the left (M*N) array as the input vector voltages of the current layer, while a constant voltage bias connects the BLs of the right (M*N) array.

3). Conductance of RRAM cell. All of the conductance values of (M*N) RRAM cells in the left array are set to a constant value as Gbias, while the conductance values of (M*N) RRAM cells in the right array are mapped to the synaptic weights of neural networks.

4). Output signal on each column. In terms of the output, the current outputs of columns are read out through SLs in parallel. Since the voltage on each SL is clamped at the ground point, the current SLP[j] and SLN[j] are added and digitalized by single-end current sense amplifiers and analog-to-digital (ADC) converters for further nonlinear activation and batch normalization operations.

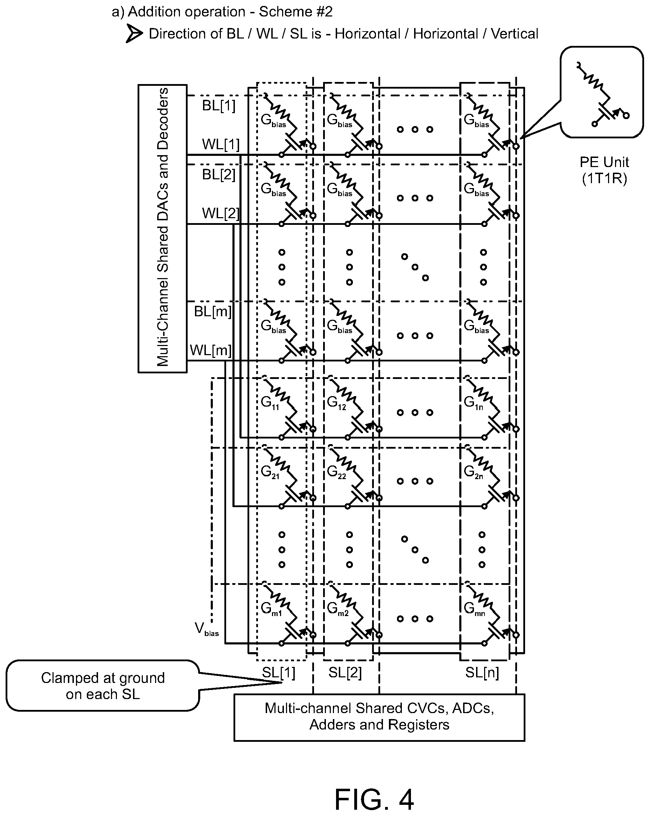

**FIG. 4** illustrates a **Scheme #2** with an RCM having a size of (2M*N) when an addition operation is applied. It contains two arrays with the same size - an upper one (M*N) and a lower one (M*N). Each processing element (PE) unit is a 1-transistor-1-resistor (1T1R) structure.

The four main aspects are described as follows:

1). Direction of BL / WL / SL. BL and WL are parallel (horizontal direction), while SL is perpendicular to BL and WL (vertical direction), which means each WL[i] can control two rows simultaneously (including upper array and lower array) corresponding to the same input BL[i] and the synaptic weights (represented as conductance G[ij]). It ultimately leads to the parallel output of current on each SL[j].

2). Input signal on each row. In terms of the input, the output vector voltages of the previous layer are fed to the BLs of the upper (M*N) array as the input vector voltages of the current layer, while a constant voltage bias connects the BLs of the lower (M*N) array.

3). Conductance of RRAM cell. As for the RRAM conductance, all of the conductance values of (M*N) RRAM cells in the upper array are set to a constant value as Gbias, while the conductance values of (M*N) RRAM cells in the lower array are mapped to the synaptic weights of neural networks.

4). Output signal on each column. The current outputs of columns are read out through SLs in parallel. Since the voltage on each SL is clamped at the ground point, the output currents of two PEs controlled by the same WL[i] are added on SL[j] thanks to the Kirchhoffs law. Then the result is digitalized by single-end current sense amplifiers and analog-to-digital converters for further nonlinear activation and batch normalization operations.

In FIG. 4 the top electrode of the RRAM cell connects to the bit line (BL) as an interface connecting the output of the previous layer and the input of the current layer, and the bottom electrode of the RRAM cell connects to the drain of the transistor. As the switch of the 1T1R unit cell, the transistor is controlled by the word line (WL). The sub-currents at the source of the transistors are collected by the source line (SL) as the current sum output of each column. However, the traditional 1T1R array is not able to perform the addition operation between the input feature (represented by the voltage signal) and synaptic weights (represented by the conductance of RRAM cell). To solve this problem, a novel topology is proposed in which an RCM 20 has a size (2M*N) when an addition operation is applied, where it contains two arrays with the same size - the upper one (M*N) and the lower one (M*N). The following will mainly describe the special points of this arrangement in terms of three aspects, i.e., the input on BL, the conductance of the RRAM cell and the output on SL.

The relationship between the output current, the input vector and synaptic weights in column j in Scheme #2 have the following equation, which verifies that this topology is able to realize the addition operation.

$$I_{SL[j]} = G_{bias} \sum_{i=1}^{m} \left( BL[i] + \frac{V_{bias}}{G_{bias}} G_{ij} \right) \qquad (2.4)$$

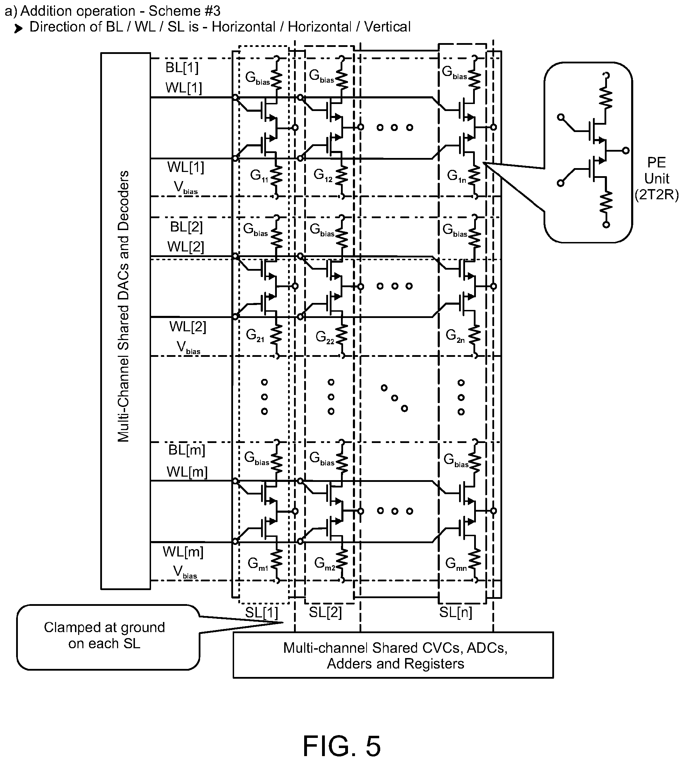

**FIG. 5** illustrates a **Scheme #3,** which has an RCM with a size (M*N) when addition operation is applied, where it is one array with the size (M*N). Each processing element (PE) unit is a 2-transistor-2-resistor (2T2R) structure. Unlike the structure of 1T1R, 2T2R (as an independent PE unit) has a more compact area in chip layout, and addition operations can be completed in a single 2T2R PE unit instead of two 1T1R PE units.

The four main aspects are described as follows:

1). Direction of BL / WL / SL. BL and WL are parallel (horizontal direction), while SL is perpendicular to BL and WL (vertical direction), which means each WL[i] can control an entire row (including n 2T2R PE units) corresponding to the same input BL[i] and the synaptic weights (represented as conductance G[ij]). It ultimately leads to the parallel output of current on each SL[j].

2). Input signal on each row. In terms of the input, the output vector voltages of the previous layer are fed to the BLs (viz. upper terminal of 2T2R PE unit) of the (M*N) array as the input vector voltages of the current layer, while a constant voltage bias connects the lower terminal of 2T2R PE unit.

3). Conductance of RRAM cell. As for the RRAM conductance, all of the conductance values of upper RRAM cells in the 2T2R PE unit are set to a constant value as Gbias, while the conductance values of lower RRAM cells in the 2T2R PE unit are mapped to the synaptic weights of neural networks.

4). Output signal on each column. The current outputs of columns are read out through SLs in parallel. Since the voltage on each SL is clamped at the ground point, the output current of a single 2T2R PE unit controlled by the same WL[i] is the result of internal addition in the 2T2R PE unit on SL[j], thanks to Kirchhoff's law. Then the result is digitalized by single-end current sense amplifiers and analog-to-digital converters for further nonlinear activation and batch normalization operations.

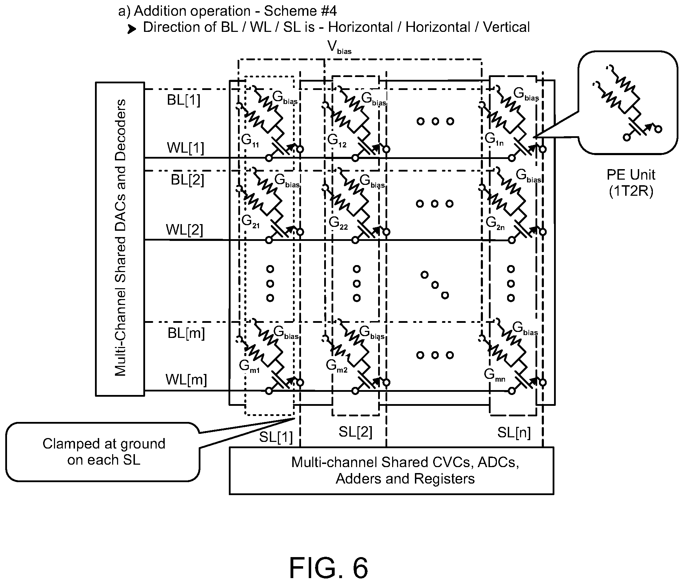

In FIG. 6 a **Scheme #4** is shown with an RCM with one array of a size of (M*N) when an addition operation is applied. Each PE unit is a 1-transistor-2-resistor (1T2R) structure. Unlike the structure of 1T1R and 2T2R, 1T2R (as an independent PE unit) has a more compact area in chip layout than the area of two 1T1R PE units or one 2T2R PE unit, and addition operations can be completed in a single 1T2RPE unit instead of two 1T1RPE units or one 2T2R PE unit.

The four main aspects are as follows:

1). Direction of BL / WL / SL. BL and WL are parallel (horizontal direction), while SL is perpendicular to BL and WL (vertical direction), which means each WL[i] can control an entire row (including n 1T2R PE units) corresponding to the same input BL[i] and the synaptic weights (represented as conductance G[ij]). It ultimately leads to the parallel output of current on each SL[j].

2). Input signal on each row. In terms of the input, the output vector voltages of the previous layer are fed to the BLs (viz. upper terminal of the 1T2R PE unit) of the (M*N) array as the input vector voltages of the current layer, while a constant voltage bias connects the left terminal of 1T2R PE unit.

3). Conductance of RRAM cell. As for the RRAM conductance, all of the conductance values of upper RRAM cells in the 1T2R PE unit are set to a constant value as Gbias, while the conductance values of lower RRAM cells in the 1T2R PE unit are mapped to the synaptic weights of neural networks.

4). Output signal on each column. The current outputs of columns are read out through SLs in parallel. Since the voltage on each SL is clamped at the ground point, the output current of a single 1T2R PE unit controlled by the same WL[i] is the result of internal addition in the 1T2R PE unit on SL[j] thanks to the Kirchhoffs law. Then the result is digitalized by single-end current sense amplifiers and analog-to-digital converters for further nonlinear activation and batch normalization operations.

. Compared with the previous Scheme #2 in **FIG. 4** one bias RRAM (Gbias) and one weight-represented RRAM (Gij) are combined together into a 1-transistor-2-resistor (1T2R) unit cell. The advantage is that one transistor can be saved so that the area of RCM can be further reduced. As for each 1T2R RRAM cell, one RRAM cell connects to the BL while another RRAM cell connects to the constant bias voltage (Vbias). The transistor is controlled by the word line (WL) as the switch of the 1T2R unit cell.

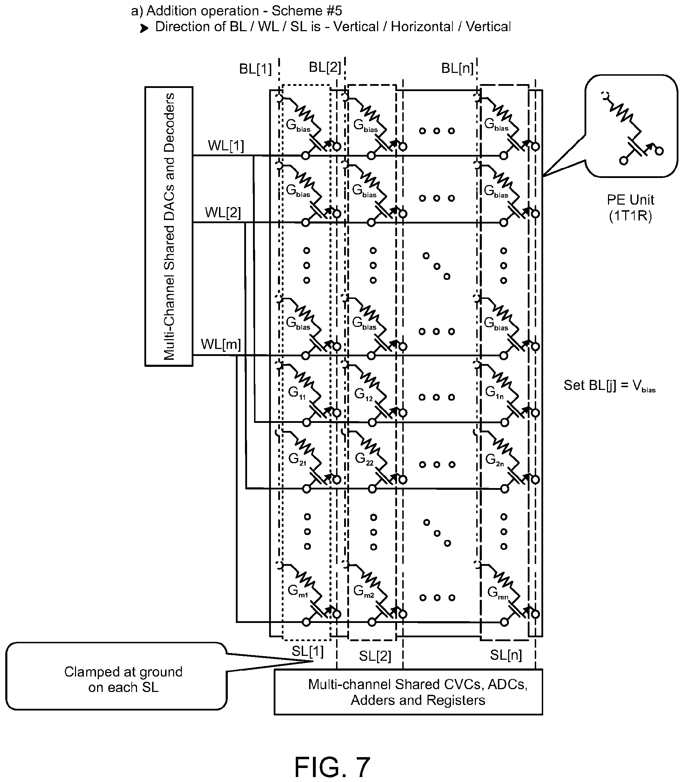

A **Scheme #5** is shown in **FIG. 7,** which has an RCM with a size of (2M*N) when it is used for an addition operation. It contains two arrays with the same size - the upper one (M*N) and the lower one (M*N). Each processing element (PE) unit is a 1-transistor-1-resistor (1T1R) structure.

The four main aspects are described as follows:

1). Direction of BL / WL / SL. BL and SL are parallel (vertical direction), while WL is perpendicular to BL and SL (horizontal direction), which means each WL[i] can control two rows simultaneously (including upper array and lower array) corresponding to the different input BL[j] and the synaptic weights (represented as conductance G[ij]). It ultimately leads to the parallel output of current on each SL[j]. Unlike scheme #2, scheme #5 employs a connectivity pattern where inputs on different columns can have different inputs (BL[j]) when one WL[i] is activated.

2). Input signal on each row. In terms of the input, the output vector voltages of the previous layer are fed to the BLs of the upper (M*N) array as the input vector voltages of the current layer, while a constant voltage bias connects the BLs of the lower (M*N) array.

3). <u>Conductance of RRAM cell.</u> As for the RRAM conductance, all of the conductance values of (M*N) RRAM cells in the upper array are set to a constant value as Gbias, while the conductance values of (M*N) RRAM cells in the lower array are mapped to the synaptic weights of neural networks.

4). <u>Output signal on each column.</u> The current outputs of columns are read out through SLs in parallel. Since the voltage on each SL is clamped at the ground point, the output currents of two PEs controlled by the same WL[i] are added on SL[j] with the same input BL[j] thanks to the Kirchhoff's law. Then the result is digitalized by single-end current sense amplifiers and analog-to-digital converters for further nonlinear activation and batch normalization operations.

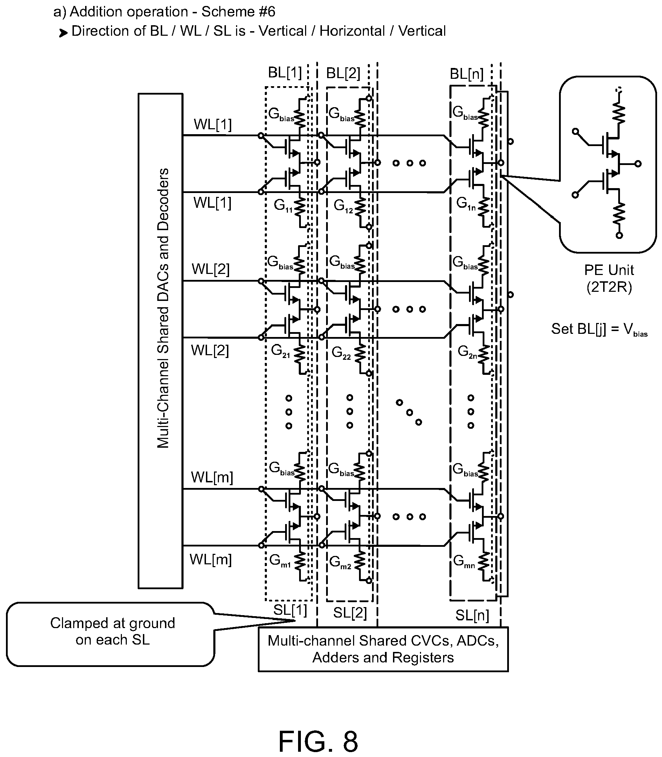

**FIG. 8** illustrates a **Scheme #6** with an RCM having one array with a size (M*N) when used for an addition operation. Each PE unit has a 2-transistor-2-resistor (2T2R) structure. Unlike the structure of 1T1R, 2T2R (as an independent PE unit) has a more compact area in chip layout, and addition operations can be completed in a single 2T2R PE unit instead of two 1T1R PE units.

The four main aspects are described as follows:

1). <u>Direction of BL / WL / SL.</u> BL and SL are parallel (vertical direction), while WL is perpendicular to BL and SL (vertical direction), which means each WL[i] can control an entire row (including n 2T2R PE units) corresponding to the same input BL[j] and the synaptic weights (represented as conductance G[ij]). It ultimately leads to the parallel output of current on each SL[j]. Unlike scheme #3, scheme #6 employs a connectivity pattern where inputs on different columns can have different inputs (BL[j]) when one WL[i] is activated.

2). <u>Input signal on each row.</u> In terms of the input, the output vector voltages of the previous layer are fed to the BLs (viz. upper terminal of 2T2R PE unit) of the (M*N) array as the input vector voltages of the current layer, while a constant voltage bias connects the lower terminal of 2T2R PE unit.

3). <u>Conductance of RRAM cell.</u> As for the RRAM conductance, all of the conductance values of upper RRAM cells in the 2T2R PE unit are set to a constant value as Gbias, while the conductance values of lower RRAM cells in the 2T2R PE unit are mapped to the synaptic weights of neural networks.

4). <u>Output signal on each column.</u> The current outputs of columns are read out through SLs in parallel. Since the voltage on each SL is clamped at the ground point, the output current of a single 2T2R PE unit controlled by the same WL[i] is the result of internal addition in the 2T2R PE unit on SL[j] thanks to the Kirchhoffs law. Then the result is digitalized by single-end current sense amplifiers and analog-to-digital converters for further nonlinear activation and batch normalization operations.

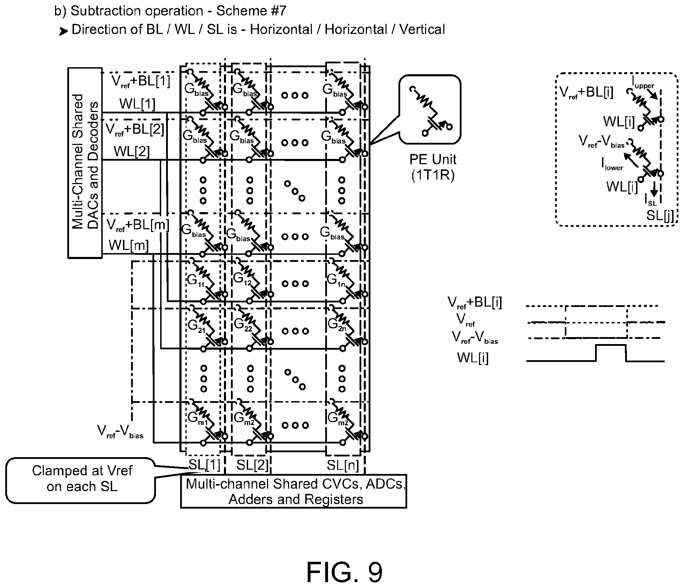

**Scheme #7** is shown in **FIG. 9.** It has an RCM with upper and lower arrays of size (2M*N) when performing a subtraction operation and uses a 1T1R PE unit. Thus, it has a structure similar to Scheme #2 of FIG. 4, except for the input voltage, bias voltage and clamped voltage on each column, and it performs subtraction instead of addition. Note that subtraction is implemented in the analog domain.

The relationship between the output current, input vector and synaptic weights in column j have the following equation, which verifies that this topology is able to realize the subtraction operation.

$$I_{SL[j]} = G_{bias} \sum_{i=1}^{m} \left( BL[i] - \frac{V_{bias}}{G_{bias}} G_{ij} \right) \qquad (2.5)$$

In traditional CNN neural networks, convolution is used to measure the similarity between input features and filters, whereas the L1-norm is applied to represent the similarity measurement in addition/subtraction-based neural networks. It should be noted that the L1-norm is the sum of the absolute difference of the components of the vectors. Therefore, it is a challenge to implement the element-wise absolute value calculation at the circuit-level. In order to handle this a sequential read-out implementation scheme is provided for the case of multi-bit quantized inputs and weights. Specifically, after the nonlinear activation operation on the previous layer, the output signal is quantized into the multi-bit in the digital domain. The digital-to-analog converters (DACs) are used to transfer the multi-bit digital signal to an analog signal as the inputs of the RCM. In addition, the synaptic weights are quantized and mapped onto their respective RRAM devices, where one single RRAM cell with multiple states represents one synaptic weight. In order to realize the element-wise absolute value calculation, the sequential read-out method is adopted, which means the CSAs and ADCs read out and digitalize the current sum on the column of the RCM in a row-by-row fashion. The format of the ADC digital output is specialized to the form that is sign bit plus absolute value bit. Then the adder and register accumulate the sum in multiple clock cycles.

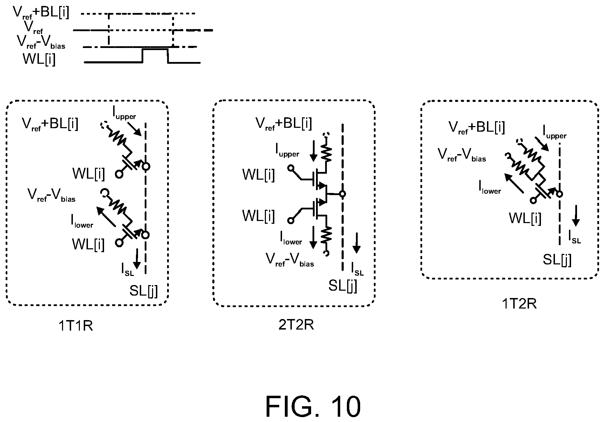

Specifically, when a subtraction operation is applied, the voltage on each source line (SL) is clamped at $V_{ref}$. The circuit also has a bit line (BL) and a word line (WL). The actual input voltage of upper array is ($V_{ref}$ + BL[i]) while the actual bias input voltage of lower array is ($V_{ref}$ - $V_{bias}$). Therefore, the upper current ($I_{upper}$) is (BL[i]*$G_{bias}$), while the lower current ($I_{lower}$) is ($V_{bias}$*$G_{ij}$). When the WL[i] line is activated, the current on the SL line ($I_{SL}$) is equal to the difference (viz. a subtraction operation) between $I_{upper}$ and $I_{lower}$, which is exactly what would be expected. **FIG. 10** shows the relationship of voltage and current at various nodes in each computing unit cell according to a subtraction case.

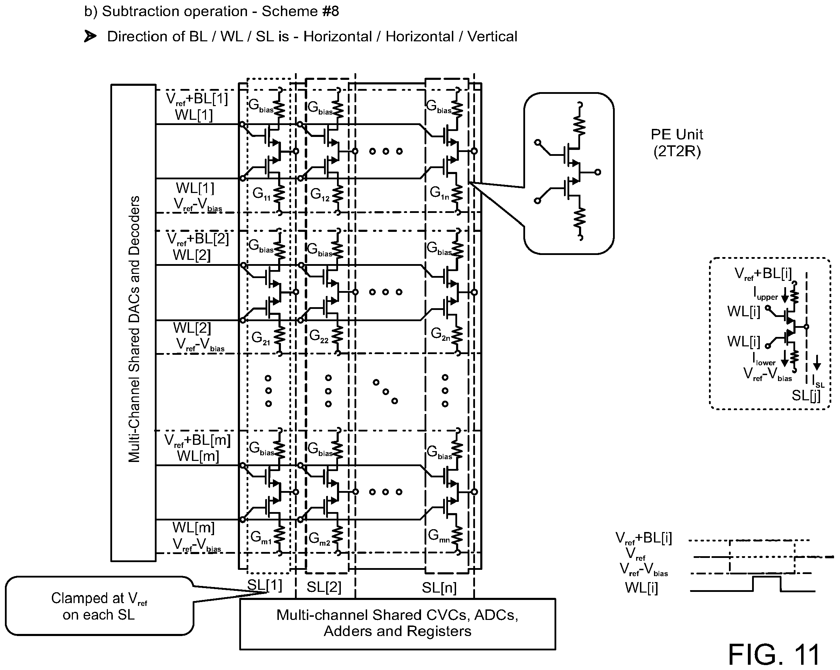

A **Scheme #8** for subtraction is shown in **FIG. 11.** It has an RCM with one array of a size (M*N) when performing a subtraction operation and uses a 2T2R PE unit, which is the more compact area in chip layout than the area of two 1T1R PE units. Thus, it has a structure similar to Scheme #3 of FIG. 5, except for the input voltage, bias voltage and clamped voltage on each column, and it is for subtraction instead of addition. Note that subtraction is implemented in the analog domain.

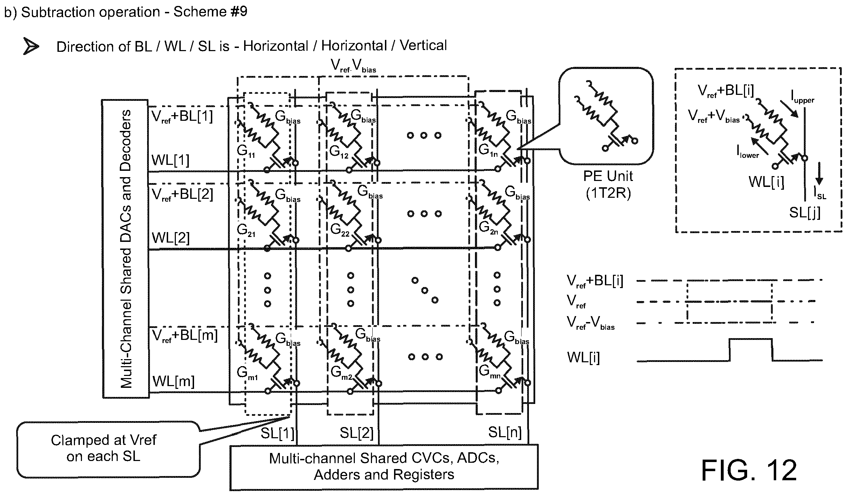

A **Scheme #9** for subtraction is shown in **FIG. 12.** It has an RCM with a single array of size (M*N) when performing a subtraction operation and uses a 1T2R PE unit, which is the more compact area in the chip layout. Subtraction operations can be completed in a single 1T2R PE unit instead of two 1T1R PE units or one 2T2R PE unit. Thus, it has a structure similar to Scheme #4 of FIG. 6, but for subtraction instead of addition. Note that subtraction is implemented in the analog domain.

Specifically, when subtraction operation is applied, the voltage on each SL is clamped at $V_{ref}$. The actual input voltage of upper array is ($V_{ref}$ + BL[i]) while the actual bias input voltage of lower array is ($V_{ref}$ - $V_{bias}$). Therefore, the upper current ($I_{upper}$) is (BL[i]*$G_{bias}$) while the lower current ($I_{lower}$) is ($V_{bias}$*$G_{ij}$). When the WL[i] is activated, the current on the SL ($I_{SL}$) is equal to the difference (viz. subtraction operation) between $I_{upper}$ and $I_{lower}$.

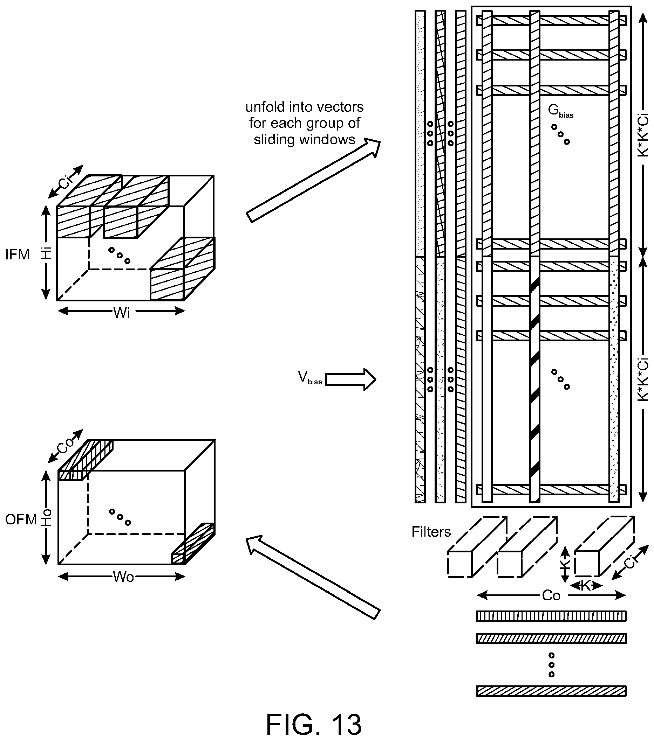

In one hidden layer of a neural network, assume that the size of the input feature map (IFM) is (Hi*Wi*Ci) and the size of the filter is (K*K*Ci*Co). As a result, the size of the output feature map (OFM) is (Ho*Wo*Co). The traditional implementation method is that the flattened (K*K*Ci) size of the input is used as the input vector of the crossbar and the same (K*K*Ci) size of the filter is used as a long column of the crossbar in a conventional scheme when applying L1-norm calculation in RCMs (**FIG. 13**). If the sequential read-out scheme is adopted because of the element-wise absolute value calculation, it definitely leads to poor parallelism and large latency.

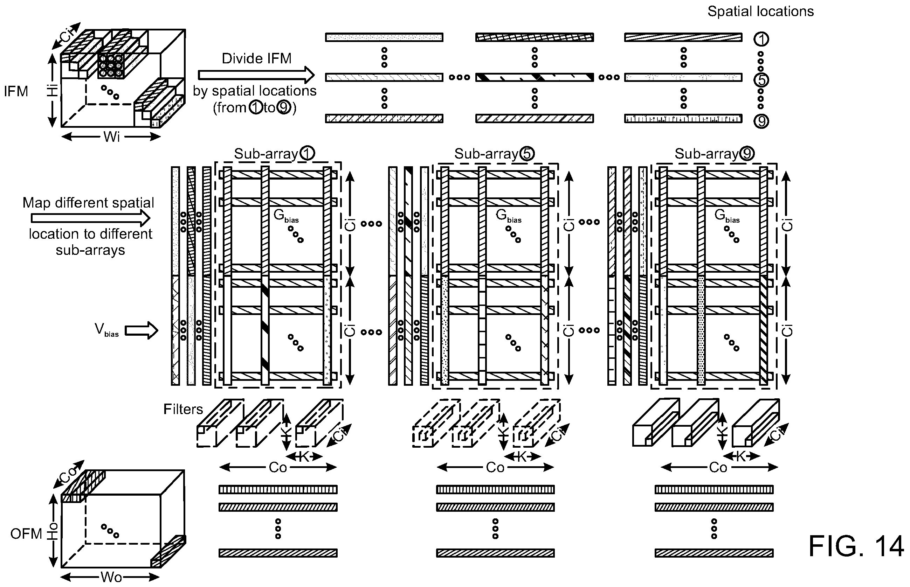

To solve this problem, inspired by the pointwise convolution, in carrying out the present invention each (K*K*Ci) filter is divided into (K*K) filters with (1*1*Ci) size for each one, during a pointwise L1-norm calculation scheme in RCMs (**FIG. 14**). In each (2Ci*Co) size RCM, we realize L1-norm similarity is realized in a pointwise domain. Moreover, there are (K*K) such RCMs. In the horizontal direction of all (K*K) of such RCMs, each element is operated in parallel. The summation of the above (K*K) pointwise results will be operated at the backend using an adder. This scheme greatly increases the parallelism and reduces the latency. In addition, this pointwise scheme reduces the frequency of data calculation due to the higher parallelism, thereby further reducing power consumption.

After rewriting eq. (2.4) and (2.5) in (2.6), it is shown that after mapping a synaptic weight of addition/subtraction-based neural networks into (Vbais/Gbias)Gij weights essentially depend on (Gij/Gbias) which is an inherent ratio between two RRAM devices that brings great benefit. Specifically, this inherent ratio-based mapping method connects the relationship between weight value and the ratio of RRAM conductance, which alleviates the impact of nonidealities of RRAM devices like variations due to process and temperature, as well as undesired relaxation over time, etc.

$$I_{SL[j]} = G_{bias} \sum_{i=1}^{m} \left( BL[i] \pm \frac{V_{bias}}{G_{bias}} G_{ij} \right) \tag{2.6}$$

Another observation from the eq. (2.6) is that there is a constant bias voltage Vbias when mapping synaptic weight into (Vbais/Gbias)Gij, which is an inherent trimming function. Specifically, this bias voltage is not only used to set the value of synaptic weights, but also to trim the nonidealities of RRAM devices like variation and relaxation.

The present invention provides a novel hardware topology that allows for the realization of addition/subtraction-based neural networks for in-memory computing. Such similarity calculations using L1-norm operations can largely benefit from the ratio of RRAM devices. The RCM structure has storage and computing collocated, such that processing is done in the analog domain with low power, low latency and small area. In addition, the impact due to the nonidealities of RRAM device can be alleviated by the implicit ratio-based feature.

The above are only specific implementations of the invention and are not intended to limit the scope of protection of the invention. Any modifications or substitutes apparent to those skilled in the art shall fall within the scope of protection of the invention. Therefore, the protected scope of the invention shall be subject to the scope of protection of the claims.

**Claims**

1. A method of measuring cross-correlation or similarity between input features and filters of neural networks using an RRAM-crossbar architecture to carry out addition/subtraction-based neural networks for in-memory computing in parallel,

   wherein the correlation calculations use L1 norm operations of AdderNet, and
   wherein an RCM structure of the RRAM-cross bar has storage and computing collocated, such that processing is done in the analog domain; and
   nonidealities of the RRAM crossbar are alleviated by the implicit ratio-based feature of the structure.

2. A fully integrated RRAM-Based AI Chip comprising

   multiple ratio-based crossbar micros (RCMs);
   global input and output buffers; and
   input/output interfaces.

3. The fully integrated RRAM-Based AI Chip according to claim 2 wherein the RCM comprises:

   a plurality of process elements (PE) that provide basic weight storage and a computation unit, wherein the PEs are arranged in rows M and columns N, and wherein inference is performed in a parallel mode by activating each row;
   multi-channel shared analog-to-digital converters (ADCs) wherein each ADC receives the output of a column of PEs and produces the output of the RCM; and
   multiple digital-to-analog converters (DAC) that apply input signals to rows of PEs as the input to the RCM.

4. The fully integrated RRAM-based AI Chip according to claim 3 wherein according to a scheme #1, the RCM has an architecture for addition with a size (M*2N) with left and right arrays and a 1T1R PE.

5. The fully integrated RRAM-Based AI Chip according to claim 3 wherein when an addition operation is to be performed, the RCM has PEs in the form of one transistor and at least one resistor (1T1R) structure, a top electrode of the RRAM connects to a bit line (BL) as an interface connecting the output of the previous layer and the input of the current layer, a bottom electrode of the RRAM cell connects to the drain of the transistor and the gate of the transistor is controlled by a word line (WL);

   wherein the sub-currents at the source of the transistors are collected by the source line (SL) as the current sum output of each column; and
   wherein according to a scheme #2 RCM has an architecture for addition with a size (2M*N), where it contains two arrays with the same size - an upper one (M*N) and a lower one (M*N), where M is the number of rows and N is the number of columns in the RRAM crossbar.

6. The fully integrated RRAM-Based AI Chip according to claim 5 wherein

   in terms of the input, the output vector voltages of the previous layer are fed to the BLs of the upper (M*N) array as the input vector voltages of the current layer, while a constant voltage bias connects the BLs of the lower (M*N) array;
   as for the RRAM conductance, all of the conductance of (M*N) RRAM cells in the upper array are set to a constant value such as Gbias, while the conductance of the (M*N) RRAM cells in the lower array are mapped to the synaptic weights of neural networks; and
   the current outputs of the columns are read out through SLs in parallel. Then the currents are digitalized by current-sense amplifiers (CSAs) and analog-to-digital converters (ADCs) for further nonlinear activation and batch normalization operations.

7. The fully integrated RRAM-based AI Chip according to claim 3 wherein according to a scheme #3, the RCM has an architecture for addition with a single size (M*N) and a 2T2R PE.

8. The fully integrated RRAM-based AI Chip according to claim 3 wherein according to a scheme #4, the RCM has an architecture for addition with a single size (M*N) and a 1T2RPE.

9. The fully integrated RRAM-Based AI Chip according to claim 8

   wherein one RRAM cell connects to the BL while the other RRAM cell connects to the constant bias voltage (Vbias), a bottom electrode of the RRAM cell connects to the drain of the transistor and the gate of the transistor is controlled by a word line (WL); and
   wherein the sub-currents at the source of the transistors are collected by the source line (SL) as the current sum output of each column.

10. The fully integrated RRAM-based AI Chip according to claim 3 wherein according to a scheme #5, the RCM has an architecture for addition with a single size (2M*N) with upper and lower arrays and a 1T1R PE.

11. The fully integrated RRAM-based AI Chip according to claim 3 wherein according to a scheme #6, the RCM has an architecture for addition with a single size (M*N) and a 2T2R PEThe fully integrated RRAM-Based AI Chip according to claim 3 wherein according to a scheme #7 for a subtraction operation is to be performed the RCM has a size (2M*1N) with upper and lower arrays and a 1T1R PE, where M is the number of rows and N is the number of columns in the RRAM crossbar;

   wherein the RCM contains two arrays with the same size - a left one (M*N) and a right one (M*N);
   wherein for the input, the output vector voltages of the previous layer are fed to the BLs of the upper (M*N) array as the input vector voltages of the current layer, while a constant voltage bias connects the BLs of the lower (M*N) array;
   all of the conductance of the (M*N) RRAM cells in the upper array are set to a constant value such as Gbias, while the conductance of the (M*N) RRAM cells in lower array are mapped to the synaptic weights of neural networks; and
   wherein for the output, the current outputs of the columns are read out through SL lines in parallel and then the current SLP[j] and SLN[j] are subtracted and digitalized by current sense amplifiers and analog-to-digital converters for further nonlinear activation and batch normalization operations.

12. The fully integrated RRAM-Based AI Chip according to claim 3 wherein according to a scheme #8 for a subtraction operation to be performed the RCM has a size (M*N) in a single array and a 2T2R PE.

13. The fully integrated RRAM-Based AI Chip according to claim 3 wherein according to a scheme #9 for a subtraction operation to be performed the RCM has a size (M*N) in a single array and a 1T1R PE.

14. The fully integrated RRAM-based AI chip according to claim 3 wherein element-wise absolute value calculation is implemented at the circuit level by a sequential read-out implementation scheme for multi-bit quantized inputs and weights, wherein the sequential read-out implementation scheme comprises the steps of:

   after a nonlinear activation operation on the previous layer, quantizing the output signal into the multi-bit in digital domain,
   using digital-to-analog converters (DACs) to transfer the multi-bit digital signal to an analog signal as the inputs of the RCM where synaptic weights are quantized and mapped onto their respective RRAM devices and one single RRAM cell with multiple states represents one synaptic weight;
   using the CSAs and ADCs to read out and digitalize the current sum on the columns of the RCM in a row-by-row fashion and
   formatting the ADC digital output in a specialized form that is the sign bit plus the absolute value bit,
   wherein optionally an adder and register accumulate the sum in multiple clock cycles.

15. The fully integrated RRAM-Based AI Chip according to claim 14 further implementing pointwise convolution comprising the steps of:

   where the size of an input feature map (IFM) is (Hi*Wi*Ci) and the size of a filter is (K*K*Ci*Co), each (K*K*Ci) filter is divided into (K*K) filters with (1*1*Ci) size for each one
   in each RCM, L1-norm similarity is realized in a pointwise domain and there are (K*K) such RCMs;
   in the horizontal direction of all (K*K) of such RCMs, each element is operated in parallel; and
   the summation of the (K*K) pointwise results are operated at the backend using an adder.

(a)

FIG.1A

(b)

FIG. 1B
(PRIOR ART)

Fully integrated RRAM-Based AI Chip

FIG. 2A

RCM 20

FIG. 2B

a) Addition operation - Scheme #1

➤ Direction of BL / WL / SL is - Horizontal / Horizontal / Vertical

FIG. 3

a) Addition operation - Scheme #2

➤ Direction of BL / WL / SL is - Horizontal / Horizontal / Vertical

FIG. 4

a) Addition operation - Scheme #3
➤ Direction of BL / WL / SL is - Horizontal / Horizontal / Vertical

FIG. 5

a) Addition operation - Scheme #4
➤ Direction of BL / WL / SL is - Horizontal / Horizontal / Vertical

FIG. 6

a) Addition operation - Scheme #5
➤ Direction of BL / WL / SL is - Vertical / Horizontal / Vertical

PE Unit
(1T1R)

Set BL[j] = V_bias

Clamped at ground
on each SL

Multi-channel Shared CVCs, ADCs,
Adders and Registers

FIG. 7

a) Addition operation - Scheme #6
➤ Direction of BL / WL / SL is - Vertical / Horizontal / Vertical

FIG. 8

b) Subtraction operation - Scheme #7

➤ Direction of BL / WL / SL is - Horizontal / Horizontal / Vertical

PE Unit
(1T1R)

Clamped at Vref
on each SL

Multi-channel Shared CVCs, ADCs,
Adders and Registers

# FIG. 9

FIG. 10

b) Subtraction operation - Scheme #8

➤ Direction of BL / WL / SL is - Horizontal / Horizontal / Vertical

FIG. 11

b) Subtraction operation - Scheme #9

➢ Direction of BL / WL / SL is - Horizontal / Horizontal / Vertical

PE Unit
(1T2R)

Clamped at Vref
on each SL

Multi-channel Shared CVCs, ADCs,
Adders and Registers

FIG. 12

EP 4 354 347 A1

unfold into vectors
for each group of
sliding windows

IFM

$H_i$

$W_i$

$C_i$

$V_{bias}$

$G_{bias}$

$K*K*C_i$

$K*K*C_i$

Filters

$K$

$K$

$C_i$

$C_o$

OFM

$H_o$

$W_o$

$C_o$

FIG. 13

EP 4 354 347 A1

FIG. 14

Europäisches
Patentamt

European
Patent Office

Office européen
des brevets

# EUROPEAN SEARCH REPORT

Application Number

EP 23 20 2358

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | YUNHE WANG ET AL: "AdderNet and its Minimalist Hardware Design for Energy-Efficient Artificial Intelligence", ARXIV.ORG, CORNELL UNIVERSITY LIBRARY, 201 OLIN LIBRARY CORNELL UNIVERSITY ITHACA, NY 14853, 3 February 2021 (2021-02-03), XP081874021, | 1 | INV. G06N3/0464 G06N3/065 ADD. G06N3/048 |
| A | * Sections 2-4 * | 2-15 | |
| X | CHI PING ET AL: "PRIME: A Novel Processing-in-Memory Architecture for Neural Network Computation in ReRAM-Based Main Memory", 2013 21ST INTERNATIONAL CONFERENCE ON PROGRAM COMPREHENSION (ICPC); [INTERNATIONAL SYMPOSIUM ON COMPUTER ARCHITECTURE.(ISCA)], IEEE, US, 18 June 2016 (2016-06-18), pages 27-39, XP032950646, ISSN: 1063-6897, DOI: 10.1109/ISCA.2016.13 ISBN: 978-0-7695-3174-8 [retrieved on 2016-08-24] | 2,3 | |
| A | * Sections II-V * | 1,4,5,10 | TECHNICAL FIELDS SEARCHED (IPC) G06N |
| X | JINSHAN YUE ET AL: "AERIS", 20190121; 1077952576 - 1077952576, 21 January 2019 (2019-01-21), pages 146-151, XP058424570, DOI: 10.1145/3287624.3287635 ISBN: 978-1-4503-6007-4 * Sections 2-6 * | 2-5,8, 10,13 | |

-/--

The present search report has been drawn up for all claims

| Place of search | Date of completion of the search | Examiner |
|---|---|---|
| The Hague | 6 March 2024 | Jacobs, Jan-Pieter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 23 20 2358

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HUANG YUXUAN ET AL: "Sparsity-Aware Non-Volatile Computing-In-Memory Macro with Analog Switch Array and Low-Resolution Current-Mode ADC", 2022 27TH ASIA AND SOUTH PACIFIC DESIGN AUTOMATION CONFERENCE (ASP-DAC), IEEE, 17 January 2022 (2022-01-17), pages 684-689, XP034089372, DOI: 10.1109/ASP-DAC52403.2022.9712556 [retrieved on 2022-02-11] * Sections III-V * | 2,3,7, 11-15 | |

TECHNICAL FIELDS
SEARCHED (IPC)

The present search report has been drawn up for all claims

| Place of search | Date of completion of the search | Examiner |
|---|---|---|
| The Hague | 6 March 2024 | Jacobs, Jan-Pieter |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
................................................................
& : member of the same patent family, corresponding
   document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 10740671 B
- US 10460817 B
- US 9646243 B

### Non-patent literature cited in the description

- **CHEN H ; WANG Y ; XU C ; SHI B ; XU C ; TIAN Q ; XU C.** AdderNet: Do we really need multiplications in deep learning?. *Proceedings of the IEEE/CVF Conference on Computer Vision and Pattern Recognition,* 2020, 1468-1477
- *AdderNet and its Minimalist Hardware Design for Energy-Efficient Artificial Intelligence, https://arxiv.org/abs/2101.10015*